# EUROPÄISCHE PATENTANMELDUNG

(11) **EP 3 029 722 A1**
(43) Veröffentlichungstag der Anmeldung: **08.06.2016**
(21) Anmeldenummer: 15197210.6
(22) Anmeldetag: 01.12.2015
(51) Int. Cl.: H01L 21/67, B23D 57/00

(54) **VERFAHREN UND VORRICHTUNG ZUM TRENNEN VON WERKSTÜCKEN AUS SPRÖDHARTEN WERKSTOFFEN**

(30) Priorität: 04.12.2014 DE 102014224902
(71) Anmelder: Technische Universität Bergakademie Freiberg, 09596 Freiberg (DE)
(72) Erfinder: AMS, Alfons, 09633 Halsbrücke (DE); KRÜGER, Thomas, 09599 Freiberg (DE)
(74) Vertreter: Pfenning, Meinig & Partner mbB

(57) **Zusammenfassung**

Die Erfindung betrifft ein Verfahren zum Trennen von Werkstücken aus sprödharten Werkstoffen, bei dem ein Werkstück mit einer translatorischen Vorschubbewegung senkrecht auf einen senkrecht dazu ausgerichteten und mit einer Vorschubgeschwindigkeit bewegten Draht zu bewegt wird. Die Vorschubbewegung des Werkstücks wird mit einer Schwingungsbewegung überlagert und dabei die Schwingungsbewegung, die mindestens einen und bis zu sechs Freiheitsgrade aufweist, mit einer Frequenz im Bereich 20 Hz bis 30 kHz durchgeführt wird

## Beschreibung

Die Erfindung betrifft ein Verfahren und eine Vorrichtung zum Trennen von Werkstücken aus sprödharten Werkstoffen.

Das Verfahren des Drahttrennläppens kommt häufig beim Trennen sprödharter Materialien zur Anwendung. In der Halbleiter-, wie auch in der Solarindustrie ist es notwendig, einkristalline bzw. polykristalline Siliziumblöcke in dünne Wafer zu zerteilen. Dabei wird ein Siliziumblock vertikal durch ein umlaufendes Drahtfeld bewegt. Vor dem Eintritt in den Sägespalt erfolgt dabei die Benetzung des Drahtes mit einer Läppemulsion, die aus einer Trägerflüssigkeit und Schneidpartikeln besteht. Die Schneidpartikel gelangen in den Sägespalt zwischen Draht und Silizium und es kommt zum Materialabtrag. Die Partikel sind üblicherweise aus relativ harten Werkstoffen, wie z.B. SiC hergestellt.

Aufgrund des Aufbringens der Läppemulsion auf der Drahteintrittseite in den Werkstoff des Werkstücks, häufen sich auf dieser Seite die Schneidpartikel im Sägespalt und der Trennprozess erfolgt ungleichmäßig. Daraus resultiert eine schlechtere Oberflächenqualität der Wafer auf der Drahtaustrittseite. Zugleich sind die Absenkgeschwindigkeit des Siliziumblockes (Vorschubgeschwindigkeit) und damit die Produktivität des Verfahrens durch die schlechten Schneideigenschaften am Drahtaustritt begrenzt. Weiterhin nimmt die Größe der Schneidpartikel in Bewegungsrichtung des Drahtes im Schnittspalt ab. Da die Breite des Schnittspaltes über die Drahtdicke und die Größe der Schneidpartikel beeinflusst wird, entstehen Wafer, deren Oberflächen nicht planparallel sind.

Zusammenfassend können drei Nachteile aufgeführt werden, die aus dem schlechten Transport der Läppemulsion von der Drahteintritt- zur Drahtaustrittseite am Werkstück resultieren.
- Schlechtere Oberflächenqualität auf der Drahtaustrittseite
- Begrenzung der Vorschubgeschwindigkeit des Siliziumblockes aufgrund der schlechten Schneideigenschaften am Drahtaustritt
- Planparallelität der Waferoberflächen ist nicht gegeben

Die zur Verbesserung der aufgeführten Nachteile ergriffenen Maßnahmen beschränken sich derzeit auf die Variation und Modifikation diverser Prozessparameter, wie die Zusammensetzung der Läppemulsion, der Viskosität oder der Drahtbeschaffenheit.

In der Waferherstellung gewinnt zunehmend das Drahtsägen mit gebundenem Korn (z.B. Diamantdraht) an Bedeutung. Dabei ist der Stahldraht mit den Schneidpartikeln belegt. Als Schneidpartikel kommen vorzugsweise Diamantpartikel zum Einsatz. Das Drahtsägen ist dabei prinzipiell ähnlich zum Trennverfahren mittels Läppemulsion (Slurry).

Aufgabe der Erfindung ist es, die Qualität der beim Trennen erhaltenen Oberflächen zu verbessern und die erforderliche Antriebsleistung zu reduzieren.

Erfindungsgemäß wird diese Aufgabe mit einem Verfahren, das die Merkmale des Anspruchs 1 realisiert, gelöst. Eine Vorrichtung zur Durchführung des Verfahrens ist mit dem Anspruch 8 definiert. Vorteilhafte Ausgestaltungen und Weiterbildungen der Erfindung können mit in untergeordneten Ansprüchen bezeichneten Merkmalen erreicht werden.

Derzeit wurde der Schneidprozess allein durch die vertikale Vorschubbewegung des Siliziumblockes und die Vorschubgeschwindigkeit des Drahtes realisiert. Die Schneideigenschaften der Partikel/Körner sollen nun durch zusätzliche oszillierende Relativbewegungen zwischen Siliziumblock und Draht verbessert werden. Die translatorischen und rotatorischen Schwingungsbewegungen können sowohl einzeln als auch kombiniert genutzt werden.

Bei dem erfindungsgemäßen Verfahren wird so vorgegangen, dass ein Werkstück mit einer translatorischen Vorschubbewegung senkrecht auf einen senkrecht dazu ausgerichteten und mit einer Vorschubgeschwindigkeit translatorisch bewegten Draht zu bewegt wird. Die Vorschubbewegung des Werkstücks wird dabei mit mindestens einer Schwingungsbewegung unter Berücksichtigung eins Freiheitsgrades überlagert. Die mindestens eine oder auch mehrere Schwingungsbewegung(en) wird/werden dabei mit einer Frequenz im Bereich 20 Hz bis 30 kHz, bevorzugt zwischen 150 Hz bis 15 kHz durchgeführt. Es kann also eine Schwingungsbewegung in mindestens einem der sechs möglichen Freiheitsgrade bei der Erfindung genutzt werden.

Es werden Frequenzen genutzt, die weit weg vom Schwingungsbereich von Ultraschallwellen liegen.

Dementsprechend kann/können eine translatorische Schwingungsbewegung parallel zur Vorschubachse des Werkstücks, parallel zur Bewegungsrichtung des Drahtes, senkrecht zur Bewegungsrichtung des Drahtes, eine rotatorische Bewegung um eine Rotationsachse, die senkrecht zur Vorschubbewegungsrichtung des Drahtes und senkrecht zur Vorschubachse des Werkstücks ausgerichtet ist, die senkrecht zur Bewegungsrichtung des Drahtes und/oder um eine Rotationsachse, die parallel zur Vorschubbewegung des Drahtes ausgerichtet ist, durchgeführt werden.

Die Schwingungsbewegung(en) sollte(n) bevorzugt mit einer Amplitude im Bereich 2 µm bis 20 µm, besonders bevorzugt mit einer Amplitude im Bereich 5 µm bis 10 µm durchgeführt werden.

Besonders geeignete Signalformen mit denen die Schwingungsbewegungen erreicht werden können, nutzen einen Signalverlauf der kontinuierlich oder zeitdiskret (impulsartig) ist. So sind beispielsweise kontinuierliche harmonische Signale oder Impulsfolgen, deren Amplitudenwerte einer harmonischen Funktion folgen, eingesetzt werden. Ebenso kann die Schwingungsbewegung stochastisch sein, d.h. die Erregung ist breitbandig (Rauschen). Es ist auch möglich, die Schwingungsbewegung über den gesamten Zeitraum des Trennens konstant zu halten. Es kann auch eine sich regelmäßig verändernde oder eine sich zufällig ändernde Art der Schwingungsbewegung gewählt werden.

Die Frequenz, die Amplitude und/oder die Art der Schwingungsbewegung kann auch in Abhängigkeit der Tiefe des Schnittspaltes variiert werden. So kann/können beispielsweise die Frequenz und/oder die Amplitude zu Beginn und am Ende des Trennvorgangs kleiner, als im Bereich dazwischen gewählt werden.

Eine optimale Erregung, die durch Frequenz, Amplitude und Schwingungsanregungsform definiert ist, kann maschinenspezifisch bestimmt werden und kann außerdem von den übrigen Prozessparametern abhängen. Neben harmonischen Erregersignalen/-impulsen für die Schwingungsbewegung des Werkstücks können auch andere Signalformen (z.B. Rechtecksignal, Sägezahn, etc) und breitbandige Erregungen (Rauschen) eingesetzt werden.

Bei einer zur Durchführung des erfindungsgemäßen Verfahrens ausgebildeten Vorrichtung ist das Werkstück mit einem Vorschubantrieb senkrecht in Richtung eines translatorisch bewegten und über mindestens zwei Rollen bewegten Drahtes zur Realisierung einer Vorschubbewegung bewegbar. Zur Überlagerung der Vorschubbewegung mit mindestens einer Schwingungsbewegung des Werkstücks ist mindestens ein Schwingungserreger, bevorzugt ein Piezoaktor an den Vorschubantrieb und das Werkstück angekoppelt.

Es können auch zwei Schwingungserreger genutzt werden. Diese können in einem Abstand zueinander und jeweils in einer Ebene mit einem Abstand zur Vorschubachse eines Drahtes angeordnet sein. Damit kann eine Schwingungsbewegung des Werkstücks erreicht werden, die in Richtung der Vorschubachse des Werkstücks erfolgt, wenn beide Schwingungserreger synchron mit gleicher Frequenz und Amplitude betrieben werden. Werden diese beiden Schwingungserreger nicht synchron, also zeitversetzt zueinander betrieben, kann eine um die Vorschubbewegungsachse des Drahtes rotierende Schwingungsbewegung realisiert werden.

Mit mindestens drei Schwingungserregern, die an das Werkstück und den Vorschubantrieb angekoppelt sind, lassen sich alle drei genannten Freiheitsgrade bei der Erfindung realisieren. So kann wieder eine rein translatorische Schwingungsbewegung jeweils zwischen zwei Umkehrpunkten erreicht werden, wenn beispielsweise alle vorhandenen Schwingungserreger zeitlich synchron mit gleicher Frequenz und Amplitude betrieben werden.

Selbstverständlich kann die Anzahl der Schwingungserreger auch größer als drei sein. Bei der Durchführung des erfindungsgemäßen Verfahrens können mehrere Schwingungserreger gleichzeitig betrieben werden. Durch eine gezielte Beeinflussung der jeweiligen Amplituden, der Phasenlagen und/oder dem Impuls/Signal mit dem die jeweiligen Schwingungserreger angesteuert und dementsprechend betrieben werden, kann die Art und Weise der jeweiligen Schwingungsbewegung(en) des Werkstücks beeinflusst werden.

Die Erfindung kann natürlich auch dann angewendet werden, wenn ein Draht mehrfach zum Trennen in mehreren Schnittspalten, die parallel nebeneinander angeordnet sind. genutzt wird. Ein Draht wird dabei mehrfach über Antriebs- und Führungsrollen geführt und bildet in einem Bearbeitungsbereich ein so genanntes Drahtfeld.

Durch die der Vorschubbewegung des Werkstücks überlagerte Schwingungsbewegung(en) können folgende Vorteile erreicht werden:
- Verbesserte Oberflächenqualität
- Verringerung der Parallelitätstoleranz zwischen den Oberflächen eines Wafers oder Werkstücks
- Reduzierung der erforderlichen Schnittkraft, dadurch Verringerung der erforderlichen Antriebsleistung
- Reduzierung der Vorschubkraft,
wodurch eine Erhöhung der Vorschubgeschwindigkeit des Werkstücks, z.B. eines Siliziumblockes und Steigerung der Produktivität des Verfahrens möglich sind.

Eine verbesserte Oberflächenqualität auf der Drahtaustrittseite und eine Verringerung der Parallelitätstoleranz können durch eine bessere Verteilung der Läppemulsion im Sägespalt erreicht werden.

Die Reduzierung der Antriebsleistung resultiert aus einer verringerten erforderlichen Schnittkraft. Die für das Drahtsägen erforderliche Wirkleistung ergibt sich als Produkt von Schnitt- bzw. Drahtgeschwindigkeit und Schnittkraft.

Versuche, bei denen ein Siliziumblock zusätzlich zur Vorschubbewegung Schwingungsbewegungen vollzogen hat, zeigen eine Verringerung der erforderlichen Vorschub- und Schnittkräfte. Andere Prozessparameter (Vorschubgeschwindigkeit, Schnittgeschwindigkeit, Temperatur der Läppemulsion, etc.) wurden bei den Untersuchungen konstant gehalten. Die Untersuchungen wurden an einer Versuchsdrahtsäge mit harmonischen Schwingungen im Frequenzbereich zwischen 150 Hz und 450 Hz sowie mit Amplituden von 5 µm und 10µm durchgeführt. Eine Verringerung der Schnittkraft durch die zusätzlich zur Vorschubbewegung durchgeführte Schwingungsbewegung ist messbar. Gute Ergebnisse wurden bei einer Anregung mit einer Frequenz von 450 Hz und 10 µm Amplitude erzielt. Hier verringerte sich die Schnittkraft um 2 - 3 % im Vergleich zum Trennen ohne zusätzliche Schwingungsbewegung. Bei weiterer Optimierung kann die erforderliche Schnittkraft und damit die erforderliche Antriebsleistung weiter bis in den Bereich um 10 % reduziert oder die Produktivität durch eine mögliche Verkürzung der Bearbeitungszeit erhöht werden. Es können auch vorteilhafte Auswirkungen auf den Verschleiß am Draht und den ggf. in einer Läppemulsion enthaltenen Schneidpartikeln erreicht werden.

Nachfolgend soll die Erfindung anhand eines Ausführungsbeispiels weiter erläutert werden.

Dabei zeigt:

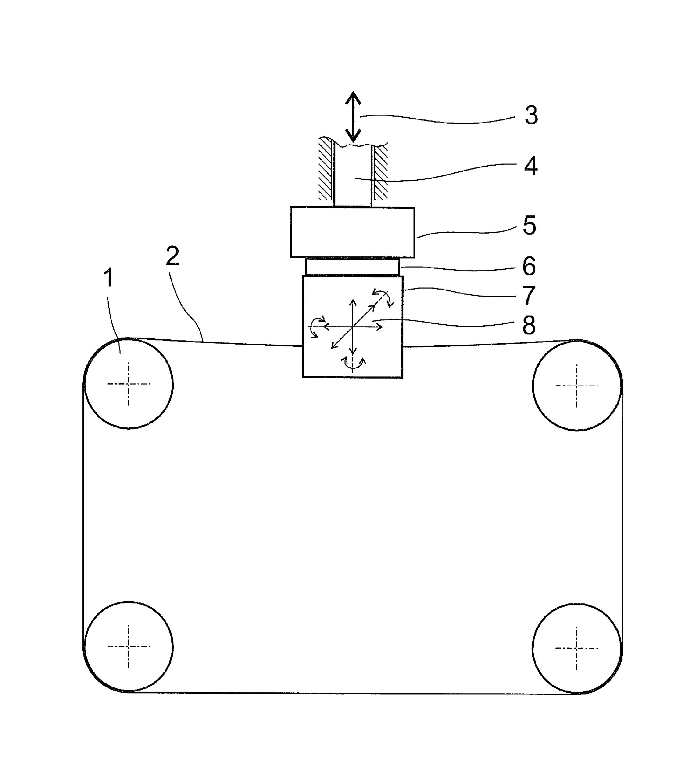

- Figur 1: in schematischer Form ein Beispiel einer bei der Erfindung einsetzbaren Vorrichtung.

Dabei wird ein Draht 2 über mehrere Rollen 1 in den Bereich eines Schnittspates eines Werkstücks 7, in diesem Fall einen Siliziumblock (Ingott) mit nahezu quadratischem Querschnitt, geführt. Dabei ist mindestens eine der Rollen 1 als Antriebsrolle ausgebildet. In allen Rollen 1 sind Führungsnuten für den Draht ausgebildet, mit denen die Richtung des Drahtes 2 für die Ausbildung der jeweiligen Schnittspalte im Werkstück 7 vorgegeben wird. Der Draht 2 ist mehrfach um die Rollen 1 geführt, so dass im Bereich des Werkstücks 7 ein Drahtfeld ausgebildet ist.

Das Werkstück 7 ist mit einem Vorschubantrieb 4 verbunden, mit dem es wie mit dem Doppelpfeil angedeutet ist, translatorisch entlang der Vorschubachse 3 bewegt werden kann. Der Vorschub wird bei einer Bewegung in Richtung Draht 2 realisiert. Bei einer entgegengesetzten Bewegung kann das Werkstück 7 mit einer Einrichtung 5 und einer Befestigung 6 für ein Werkstück 7 wieder aus dem Einflussbereich des Drahtes 2 heraus bewegt werden, wenn beispielsweise ein Trennvorgang beendet und ein Austausch eines neuen Werkstücks 7 vorgenommen werden soll.

In der Einrichtung 5 ist mindestens ein Schwingungserreger aufgenommen, mit dem Schwingungsbewegungen des Werkstücks 7 initiiert werden können, wenn der Draht in berührendem Kontakt zu dem Werkstoff des Werkstücks 7 steht und der Draht 2 eine Schneidbewegung, die zumindest nahezu senkrecht zur Vorschubachse 3 des Werkstücks 7 ausgerichtet ist, vollzieht.

Mit mehreren Schwingungserregern, die in der Einrichtung 5 vorhanden sein können, lassen sich mehrere Schwingungsbewegungen des Werkstücks 7, wie sie mit dem Koordinatenkreuz 8 angedeutet sind, sukzessive nacheinander oder auch gleichzeitig in überlagerter Form durchführen. Die eine oder mehrere Schwingungsbewegung(en) wird/werden dabei der Vorschubbewegung des Werkstücks 7 überlagert. So kann eine Schwingungsbewegung allein translatorisch parallel zur Vorschubachse 3 des Werkstücks 7 erreicht werden.

Allein oder zusätzlich kann auch eine rotierende Schwingungsbewegung des Werkstücks 7 um eine Achse, die parallel zum Draht 2 ausgerichtet ist, erreicht werden. Eine weitere Art der Schwingungsbewegung kann erreicht werden, wenn eine rotierende Schwingungsbewegung um eine Achse, die sowohl senkrecht zur Achse der Vorschubbewegung des Drahtes 2, wie auch senkrecht zur Vorschubachse 3 des Werkstücks 7 ausgerichtet ist, durchgeführt wird.

Gemäß weiterer möglicher Freiheitsgrade kann auch eine translatorische Schwingungsbewegung parallel und/oder senkrecht zur Bewegungsrichtung des Drahtes 2 sowie um eine Achse, die parallel zur Vorschubachsrichtung 3 ausgerichtet ist, erreicht und ausgenutzt werden.

Wie bereits angesprochen können mehrere dieser Schwingungsbewegungen gleichzeitig in überlagerter Form durchgeführt werden.

Die Vorschubgeschwindigkeit mit der das Werkstück 7 beim Trennen in Richtung Draht 2 bewegt wird, liegt im üblichen Bereich um 0,4 mm/min.

In nicht dargestellter Form kann zusätzlich auch eine Zuführung von Läppemulsion vorhanden sein, wie sie üblicherweise beim Drahttrennläppen eingesetzt wird.

## Patentansprüche

1. Verfahren zum Trennen von Werkstücken aus sprödharten Werkstoffen, bei dem
ein Werkstück (7) mit einer translatorischen Vorschubbewegung senkrecht auf einen senkrecht dazu ausgerichteten und mit einer Vorschubgeschwindigkeit bewegten Draht (2) zu bewegt wird und
die Vorschubbewegung des Werkstücks (7) mit einer Schwingungsbewegung überlagert und dabei die Schwingungsbewegung, die mindestens einen und bis zu sechs Freiheitsgrade aufweist, mit einer Frequenz im Bereich 20 Hz bis 30 kHz durchgeführt wird.

2. Verfahren nach Anspruch 1, **dadurch gekennzeichnet, dass** die Schwingungsbewegung mit einer Amplitude im Bereich 2 µm bis 20 µm, bevorzugt mit einer Amplitude im Bereich 5 µm bis 10 µm durchgeführt wird.

3. Verfahren nach Anspruch 1 oder 2, **dadurch gekennzeichnet, dass** die Schwingungsbewegung mit einem Signalverlauf, der kontinuierlich oder zeitdiskret (impulsartig) ist, insbesondere in Form kontinuierlich harmonischer Signale oder Impulsfolgen, deren Amplitudenwerte einer harmonischen Funktion folgen, erfolgt oder die Schwingungsbewegung stochastisch, sich regelmäßig verändernd oder sich zufällig verändernd durchgeführt wird.

4. Verfahren nach einem der vorhergehenden Ansprüche, **dadurch gekennzeichnet, dass** die Frequenz, die Amplitude und/oder die Art der Schwingungsbewegung in Abhängigkeit der Tiefe des Schnittspaltes variiert wird.

5. Verfahren nach einem der vorhergehenden Ansprüche, **dadurch gekennzeichnet, dass** das Verfahren als Drahtsägeverfahren, Drahttrennschleifverfahren oder als Drahttrennläppverfahren durchgeführt wird.

6. Verfahren nach einem der vorhergehenden Ansprüche, **dadurch gekennzeichnet, dass** mehrere translatorische und/oder rotatorische Schwingungsbewegungen zu einer mehrachsigen Schwingungsbewegung überlagert werden.

7. Verfahren nach einem der vorhergehenden Ansprüche, **dadurch gekennzeichnet, dass** durch eine gezielte Beeinflussung der jeweiligen Amplituden, der Phasenlagen und/oder dem Impuls/Signal mit dem die jeweiligen Schwingungserreger angesteuert, und dementsprechend betrieben werden, wird die Art und Weise der jeweiligen Schwingungsbewegung(en) des Werkstücks beeinflusst.

8. Vorrichtung zur Durchführung des Verfahrens nach einem der vorhergehenden Ansprüche, **dadurch gekennzeichnet, dass** das Werkstück (7) mit einem Vorschubantrieb (3) senkrecht in Richtung eines translatorisch bewegten und über mindestens zwei Rollen (1) bewegten Draht (2) zur Realisierung einer Vorschubbewegung bewegbar und zur Überlagerung der Vorschubbewegung mit mindestens einer Schwingungsbewegung des Werkstücks (7), mindestens ein Schwingungserreger, bevorzugt ein Piezoaktor an den Vorschubantrieb (3) und das Werkstück (7) angekoppelt ist.

9. Vorrichtung nach Anspruch 7, **dadurch gekennzeichnet, dass** zwei Schwingungserreger in einem Abstand zueinander und jeweils in einer Ebene mit einem Abstand zur Vorschubachse eines Drahtes (2) angeordnet sind.

10. Vorrichtung nach einem der beiden vorhergehenden Ansprüche, **dadurch gekennzeichnet, dass** mindestens drei Schwingungserreger an das Werkstück (7) und den Vorschubantrieb (3) angekoppelt sind.
